# EUROPÄISCHE PATENTSCHRIFT

(11) **EP 1 996 753 B1**
(45) Veröffentlichungstag und Bekanntmachung des Hinweises auf die Patenterteilung: **25.09.2013**
(21) Anmeldenummer: 07817995.9
(22) Anmeldetag: 22.03.2007
(51) Int. Cl.: C04B 35/622, D01F 8/18, D01F 9/10

(54) **METALLISCHE NANODRÄHTE MIT EINER HÜLLE AUS OXID UND HERSTELLUNGSVERFAHREN DERSELBEN**
METAL NANOWIRES WITH AN OXIDE SHEATH AND PRODUCTION METHOD FOR SAME
NANOFILS MÉTALLIQUES DOTÉS D'UNE GAINE EN OXYDE ET PROCÉDÉ DE FABRICATION DE CEUX-CI

(30) Priorität: 23.03.2006 DE 102006013484
(43) Veröffentlichungstag der Anmeldung: 03.12.2008
(73) Patentinhaber: Leibniz-Institut für Neue Materialien gemeinnützige GmbH, 66123 Saarbrücken (DE)
(72) Erfinder: VEITH, Michael, 66386 St. Ingbert (DE); PETERSEN, Christian, 52064 Aachen (DE); SOW, Eve, Awa, 2513 Den Haag (NL)
(74) Vertreter: Gierlich, Johannes
(86) Internationale Anmeldenummer: PCT/EP2007/002564
(87) Internationale Veröffentlichungsnummer: WO 2008/011920

(56) Entgegenhaltungen:
- WO-A-02/02233
- ZHANG Y F ET AL.: "Germanium nanowires sheathed with an oxide layer" PHYSICAL REVIEW, B. CONDENSED MATTER, AMERICAN INSTITUTE OF PHYSICS. NEW YORK, US, Bd. 61, Nr. 7, 15. Februar 2000 (2000-02-15), Seiten 4518-4521, XP002451770 ISSN: 0163-1829
- DATABASE WPI Week 200564 Derwent Publications Ltd., London, GB; AN 2005-620622 XP002451773 & CN 1 626 300 A (INST METAL CAS) 15. Juni 2005 (2005-06-15)
- MARTIN C R: "Nanomaterials: A Membrane-Based Synthetic Approach" SCIENCE, AMERICAN ASSOCIATION FOR THE ADVANCEMENT OF SCIENCE,, US, Bd. 266, Nr. 5193, 23. Dezember 1994 (1994-12-23), Seiten 1961-1966, XP002451771 ISSN: 0036-8075 in der Anmeldung erwähnt

## Beschreibung

Die Erfindung betrifft eindimensionale Nanodrähte bestehend aus einem metallischen Kern und ummantelt mit einem Metalloxid, insbesondere einem keramischen Material, sowie verzweigte Nanostrukturen aufgebaut aus vorgenannten ummantelten Nanodrähten, ein Verfahren zu deren Herstellung sowie deren Verwendung.

Im Rahmen der allgemeinen Miniaturisierung, vor allem im Bereich der elektronischen Bauelemente, verändern sich die Eigenschaften der verwendeten Materialien, je weiter man in den Submikrometerbereich vorstößt. Angewendet werden bisher hauptsächlich Nanopartikel, die in allen drei Raumrichtungen Abmessungen im Nanometerbereich haben (sogenannte 0-dimensionale Strukturen), sowie dünne, Schichten, deren Abmessung in einer Raumrichtung im Nanometerbereich liegen (sogenannte 2-dimensionale Strukturen).

Vor allem durch die Verkleinerung elektronischer Bauelemente, aber auch durch die Miniaturisierung in anderen Bereichen, tritt zunehmend auch der Bedarf an Fasern bzw. Drähten, verzweigten Drähten, Kabeln sowie Netzwerken derselben im Submikrometerbereich (sogenannte 1-dimensionale Strukturen) auf.

Bisherige Verfahren zur Erzeugung solcher eindimensionaler Strukturen bestehen hauptsächlich in der Verwendung von Edelmetallkatalysatoren oder der Verwendung von Templaten. Wu et al., J. Am. Chem. Soc., 2001; 123:3165-3166, beschreiben z.B. die Herstellung von Ge-Nanodrähten, wobei Göld-Nanocluster als Katalysatoren eingesetzt werden. Ein Templat gesteuertes Verfahren wird z.B. von Martin, Science, 1994; 266:1961-1966, beschrieben. Nachteilig bei all diesen Verfahren ist, dass sie den Einsatz von fremden Materialien, wie Katalysatoren oder Templaten, erfordern, die zu Verunreinigungen der entsprechenden Strukturen führen.

Eine Übersicht über Nanodrähte und deren Herstellung findet man in Xia et al., Adv. Mater. 2003, 15, Nr. 5, S. 353-389. Häufig sind die Arbeiten nach dem Stand der Technik auf Nanodrähte aus einem Material gerichtet. Für die Verwendung z.B. als Miniaturbausteine ist aber häufig eine Kombination verschiedener Eigenschaften erforderlich. Dies kann in der Regel nur durch Kompositstrukturen erreicht werden, also Strukturen, die aus einer Kombination von zwei oder mehr Materialien aufgebaut sind.

Zhang et al., Phys. Rev. B Condensed Matter 2000, 61, Nr. 7, S. 4518-4521 beschreibt die Herstellung von Germanium-Nanodrähten, welche mit Germaniumoxid ummantelt sind, durch Laserablation.

CN 1 626 300 A beschreibt mit Aluminiumoxid beschichtete Nanodrähte mit einem metallischem Kern.

Aufgabe der vorliegenden Erfindung ist die Bereitstellung von eindimensionalen Kompositstrukturen, die aus einer Kombination unterschiedlicher Materialien bestehen, so dass unterschiedliche Eigenschaften kombiniert werden können. Ferner sollen eindimensionale Kompositstrukturen bereitgestellt werden, die möglichst frei von Verunreinigungen, insbesondere von Resten von Katalysatoren oder Templaten, sind.

Die Aufgabe konnte überraschenderweise gelöst werden durch Bereitstellung linearer oder verzweigter Nanodrähte aus einem metallischen Kern aus einem Metall der dritten Hauptgruppe, der mit einem Metalloxid, insbesondere einem keramischen Material ummantelt ist. Diese Nanodrähte können unter Verwendung flüchtiger metallorganischer Verbindungen ohne Einsatz fremder Substanzen hergestellt werden. Dies erlaubt es, sie unter wirtschaftlichen Bedingungen und mit hoher Ausbeute herzustellen.

Die Erfindung betrifft daher eine eindimensionale Kompositstruktur, die mindestens einen Nanodraht umfassend einen metallischen Kern aus einem Metall der dritten Hauptgruppe, der mit einem Metalloxid ummantelt ist, oder mindestens eine verzweigte Struktur, die aus solchen Nanodrähten aufgebaut ist, umfasst. Die Erfindung betrifft ferner ein Verfahren zur Herstellung der eindimensionalen Kompositstrukturen sowie die Verwendung dieser Strukturen, wie in den Ansprüchen definiert. Die erfindungsgemäßen Strukturen bestehen aus einem metallischen Kern und eine Metalloxidhülle, insbesondere einer keramischen Hülle, und können daher auch als Kabel bezeichnet werden.

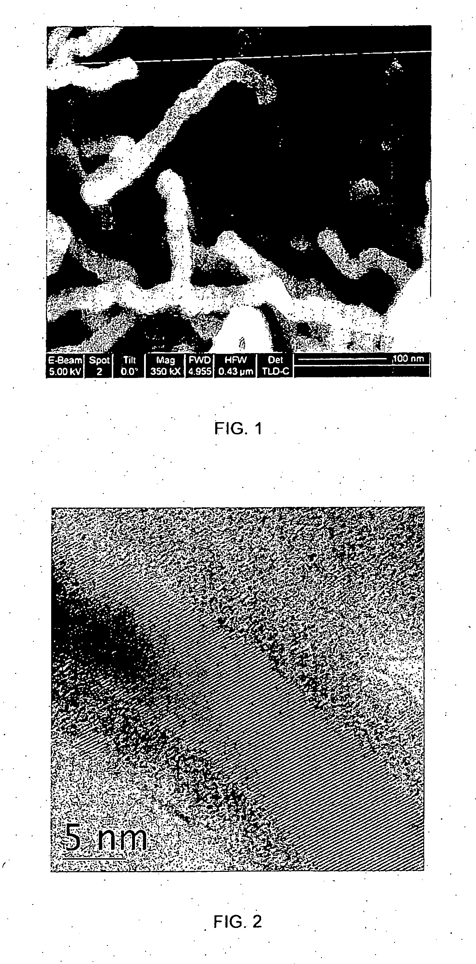

Fig. 1 zeigt eine REM-Aufnahme der erfindungsgemäßen Strukturen. Fig. 2 zeigt eine TEM-Aufnahme, aus der die Kompositstruktur aus Hülle und Kern ersichtlich wird.

Der Nanodraht umfasst einen metallischen Kern, der von einem Metalloxid ummantelt ist. Der metallische Kern besteht aus einem Metall der III. Hauptgruppe. Beispiele sind Al, Ga, In und Tl, wobei Aluminium und Gallium besonders bevorzugt sind. Die Hülle besteht aus einem Metalloxid und insbesondere einem Metalloxid eines Metalls der III. Hauptgruppe, wie Al, Ga, In und Tl, wobei ein Aluminiumoxid und ein Galliumoxid besonders bevorzugt sind. In einer bevorzugten Ausführungsform sind sowohl das Metall des Kerns als auch das Metall des Metalloxids ein Metall der III. Hauptgruppe, wobei das Metall des Kerns und das Metall des Metalloxids besonders bevorzugt dasselbe Metall der III. Hauptgruppe sind.

Das Metalloxid kann jedes übliche Oxid sein. Es umfasst Oxide in allen üblichen Oxidationsstufen der Metalle und auch Mischoxide, in denen das Metall in unterschiedlichen Oxidationsstufen enthalten ist. Die Oxide können amorph oder bevorzugt kristallin vorliegen. Die Oxide umfassen alle üblichen Kristallformen. Beispiele sind α-Al₂O₃, γ-Al₂O₃, α-Ga₂O₃, β-Ga₂O₃ und In₂O₃. Das Metalloxid ist bevorzugt eine Keramik bzw. ein keramisches Material.

Gegebenfalls können Kern und/oder Hülle geringe Mengen an Verunreinigungen enthalten, z.B. Zwischenprodukte oder Nebenprodukte aus den Ausgangsverbindungen. Die Kompositstrukturen sind aber bevorzugt im wesentlichen frei von Verunreinigungen. Insbesondere enthalten sie keine Rückstände, die von Katalysatoren oder Templatmaterialien stammen.

Die eindimensionale Kompositstruktur ist ein Kömposit aus einem metallischen Kern und einer Metalloxid-Hülle. Die eindimensionale Kompositstruktur kann einen oder mehrere Nanodrähte des beschriebenen Aufbaus umfassen bzw. daraus bestehen. Neben diesen einfachen, linearen, kabelartigen, eindimensionalen Strukturen kann die eindimensionale Kompositstruktur alternativ oder zusätzlich eine oder mehrere verzweigte Strukturen umfassen bzw. daraus bestehen, die aus mehreren, astartig aufeinander aufgewachsenen Nanodrähten der linearen Form aufgebaut sind. Diese beiden Formen können auch als lineare bzw. verzweigte Nanodrähte bezeichnet werden. Bei der verzweigten Form können die metallischen Kerne der Drähte sich an den Verzweigungen berühren oder die Metallkerne können an den Verzweigungen durch die Metalloxidhülle voneinander getrennt sein. Die eindimensionale Kompositstruktur kann frei vorliegen oder sich auf einem Substrat befinden.

Die erfindungsgemäßen Nanodrähte besitzen insbesondere zwei Dimensionen, die im Bereich unterhalb von 200 nm liegen, z.B. im Bereich von 1 bis 200 nm und bevorzugt von 10 bis 100 nm, insbesondere etwa 20 bis 40 nm. Das Verhältnis von Breite zu Länge der Nanodrähte ist im allgemeinen mindestens 1:3 und bevorzugt mindestens 1:5. Die dritte Dimension liegt in der Regel im Mikrometer- und Submikrometerbereich. Der Querschnitt der Nanodrähte ist in der Regel annähernd kreisförmig.

Metallorganische Verbindungen dienen in bestimmten Bereichen als Vorläufer (Precursoren) für andere Werkstoffe. So können flüchtige Precursoren mit Hilfe des sogenannten "Metal Organic Chemical Vapor Deposition"-Verfahrens (MO-CVD) zu dünnen Schichten keramischer Materialien mit sehr hoher Qualität umgesetzt werden. Das MO-CVD-Verfahren besteht in einem chemischen Aufdampfen von metallorganischen Verbindungen. Im MO-CVD-Verfahren ist eine hinreichende Flüchtigkeit des Precursors unter Reaktionsbedingungen erforderlich, wobei aber für die Prozesssteueruhg umgekehrt eine gewisse Stabilität dieser Verbindung unter Normalbedingungen notwendig ist. Entsprechende Precursoren zur Erzeugung von flächigen Mikro- und Nanokompositen sind z.B. aus DE-A-4221659 bekannt.

Bei dem erfindungsgemäßen Verfahren werden eindimensionale Kompositstrukturen durch ein MO-CVD-Verfahren erhalten. Hierfür wird eine metallorganische Verbindung unter Bildung der Struktur thermolytisch zersetzt. Es handelt sich um ein katalysatorfreies und templaffreies Verfahren. Die verwendeten metallorganischen Verbindungen besitzen folgende allgemeine Formel:

EI(OR)H₂

worin El die Elemente Al, Ga, In oder Tl bedeutet, wobei Al und Ga bevorzugt sind, und R für einen aliphatischen oder alicyclischen Kohlenwasserstoffrest steht.

Der aliphatische oder alicyclische Kohlenwasserstoffrest ist bevorzugt ungesättigt. Er kann z.B. 1 bis 15 C-Atome aufweisen. Bevorzugt sind Alkyl oder unsubstituiertes oder Alkyl-substituiertes Cycloalkyl. Der Alkylrest besitzt vorzugsweise 2 bis 12 C-Atome, bevorzugt 3 bis 10 C-Atome. Das Alkyl kann linear oder verzweigt sein, wobei verzweigte Alkylreste bevorzugt sind. Beispiele sind Ethyl, n-Propyl, n-Butyl und die entsprechenden höheren linearen Homologe, Isopropyl, sek.-Butyl, tert.-Butyl, Neopentyl, Neohexyl und die entsprechenden höheren Isoalkyl- und Neoalkylhomologe oder 2-Ethylhexyl. Die alicyclischen Reste können einen, zwei oder mehr Ringe umfassen, die jeweils mit Alkyl substituiert sein können. Der alicyclische Rest umfasst bevorzugt 5 bis 10 und insbesondere 5 bis 8 Kohlenstoffatome. Beispiele für geeignete Cycloalkyle sind Cyclopentyl, Cyclohexyl, Methylcyclohexyl, Norbornyl und Adamantyl.

Besonders geeignet sind Aluminiumalkoxydihydride, die verzweigte C₄-C₈-Alkoxyreste aufweisen, insbesondere Aluminium-tert.-butoxydihydrid. Die Herstellung von Verbindungen der allgemeinen Formel El(OR)H₂ ist bekannt und wird in DE-A-19529241 beschrieben. Sie können z.B. durch Umsetzung des El-hydrids mit dem entsprechenden Alkohol im Molverhältnis 1:1 erhalten werden, wobei das El-hydrid in situ durch Reaktion eines Alkali-El-hydrids mit El-halogenid hergestellt werden kann. Verbindungen der Formel El(OR)H₂, worin El Al oder Ga ist, und deren Herstellung werden auch in M. Veith et al., Chem. Ber. 1996, 129, 381-384, beschrieben. In diesem Artikel wird auch gezeigt, das die Verbindungen der Formel El(OR)H₂ auch dimere Strukturen umfassen können.

Die metallorganischen Verbindungen werden in die Gasphase überführt und thermolytisch zersetzt, wobei das nichtflüchtige Zersetzungsprodukt in der Regel an oder auf einem Substrat in Form der eindimensionalen Kompositstruktur gebildet wird. Als Substrate kommen prinzipiell alle üblichen Materialien in Betracht, z.B. Glas, Keramik, Metall, Silizium oder Quarz, die bevorzugt inert gegenüber den Ausgangs- und Endprodukten sind. Die Thermolyse kann z.B. in einem Ofen, an einer induktiv beheizten Oberfläche oder an einer auf einem induktiv geheizten Probenträger befindlichen Oberfläche durchgeführt werden. Als Substratmaterialien für die direkte induktive Heizung kommen lediglich elektrisch leitfähige Materialien, wie Graphit oder Metalle, in Frage. Bei der Verwendung von Substraten mit geringerer elektrischer Leitfähigkeit wie Glas, Quarz, Silizium, Aluminiumoxid muss ein Ofen oder, im Falle der induktiven Heizung, ein elektrisch leitender Substratträger, z.B. aus Graphit oder Metall, verwendet werden. Das Substrat kann somit eine Oberfläche des Reaktionsraums oder ein darin platziertes Substrat, z.B. ein Plättchen oder eine Folie, sein.

Der eingesetzte Reaktorsraum kann jede beliebige Gestalt aufweisen. Es kann sich z.B. um ein Reaktionsrohr handeln. Als Reaktormaterial kann jedes übliche inerte Material verwendet werden, z.B. Duran- oder Quarzglas. Der zur Durchführung des Verfahrens eingesetzte Reaktor ist an das jeweilige Substrat bzw. die Dimensionen des Substrates anzupassen. Beispielsweise kann für ein rundes Substrat mit einem Durchmesser von 2,5 cm ein Reaktordurchmesser von 5 cm und für ein Substrat mit einem Durchmesser von 50 cm ein Reaktordurchmesser von 55 cm eingesetzt werden.

Die Erzeugung der erfindungsgemäßen eindimensionalen Strukturen hängt wesentlich von der verwendeten Temperatur für die thermolytische Zersetzung und damit von der Substrattemperatur ab. Die gewünschten Strukturen entstehen bei erhöhten Temperaturen von über 400°C, bevorzugt bei Temperaturen von mindestens 450°C. Bevorzugt sind Temperaturen von nicht mehr als 1200°C und insbesondere nicht mehr als 600°C, z.B. von 400°C bis 1200°C und vorzugsweise von 450 bis 650°C, am meisten bevorzugt von 450°C bis 600°C verwendet. Das Substrat, auf bzw. an dem die Thermolyse stattfindet, wird dementsprechend auf die gewünschte Temperatur erhitzt. Die Erzeugung der erfindungsgemäßen Strukturen ist dabei unabhängig vom verwendeten Substratmaterial und dessen Beschaffenheit.

Die metallorganische Verbindung bzw. der Precursor kann aus einem Vorratsgefäß, das bevorzugt auf eine gewünschte Verdampfungstemperatur temperiert ist, in den Reaktor eingeleitet werden. Das Vorratsgefäß kann z.B. auf eine Verdampfungstemperatur im Bereich von -50°C bis 120°C, vorzugsweise von -10°C bis 40°C temperiert werden. Die Thermolyse im Reaktorraum erfolgt in der Regel bei Atmosphärendruck oder Unterdruck, bevorzugt bei einem Vakuum von in der Regel 10⁻⁶ mbar bis Atmosphärendruck und bevorzugter im Bereich von 10⁻² mbar bis 10⁻¹ mbar. Zur Erzeugung eines Vakuums kann ausgangsseitig ein Vakuumpumpensystem an den Reaktor angeschlossen werden. Es können alle üblichen Vakuumpumpen verwendet werden, bevorzugt ist eine Kombination aus Drehschieberpumpe und Turbomolelekülarpumpe oder eine Drehschieberpumpe. Zweckmäßigerweise ist auf einer Seite des Reaktorraums das Vorratsgefäß für den Precursor angebracht und auf der anderen Seite das Vakuumpumpensystem.

Vor der Durchführung des Verfahrens kann der Reaktorraum durch ein- oder mehrfaches Durchspülen von Inertgas, wie Stickstoff oder Argon, gegebenenfalls unter zwischenzeitlichem Anlegen eines Vakuums, inertisiert werden. Nach Einstellen der gewünschten Bedingungen wird der Precusor über einen gewissen Zeitraum in den Reaktor eingeleitet, so dass er an bzw. auf dem Substrat unter Bildung der eindimensionalen Kompositstruktur thermolytisch zersetzt wird.

Bei Erhitzung des Substrats durch Induktion können z.B. quadratzentimetergroße, elektrisch leitende Metallplättchen oder -folien als Substrat in einem Reaktionsrohr aus Duran- oder Quarzglas angeordnet werden. An dem Reaktionsrohr sind eingangsseitig das auf die gewünschte Verdampfungstemperatur temperierte Vorratsgefäß mit dem Precursor und ausgangsseitig ein Vakuumpumpensystem angeschlossen. Das Reaktionsrohr befindet sich in einem Hochfrequenzinduktionsfeld, mit dessen Hilfe die Substratplättchen oder -folien auf die gewünschte Temperatur erhitzt werden. Nach Einstellen des gewünschten Drucks und Einleiten des Precursors wird das Substrat mit den eindimensionalen Strukturen bedeckt.

Die genaue morphologische Ausprägung der erfindungsgemäßen eindimensionalen Strukturen kann durch geeignete Auswahl der Parameter des Verfahrens gesteuert werden. Durch gezielte Wahl von Substrattemperatur und Precursorfluss (Menge an eingeleitetem Precursor pro Zeiteinheit), welcher wiederum durch gezielte Einstellung der Precursorvorlagentemperatur und der Wahl des Druckes im Reaktor steuerbar ist, können Länge, Dicke und/oder Verzweigung der Strukturen beeinflusst werden.

Sollen die eindimensionalen Strukturen, insbesondere die eindimensionalen Nanostrukturen vom Substrat unabhängig verwendet werden, so können die auf einem Substrat erzeugten Strukturen von dem Substrat abgekratzt oder abgelöst werden und entsprechend weiter verwendet werden.

Die Morphologie und die Vorteile des Kompositmaterials der erfindungsgemäßen Strukturen können auf vielen Anwendungsgebieten genutzt werden. Da der metallische Kern elektrisch leitend ist und die Hülle aus Metalloxid einen elektrischen Isolator darstellt, eignen sich die Strukturen ausgezeichnet als elektrische Kabel im Nanomaßstab. Durch Keramikummantelung isolierte, elektrisch leitende Nanodrähte und Netzwerke bieten somit zahlreiche Anwendungen in der Nanoelektronik. Sie eignen sich insbesondere für nanoelektronische, optische oder magnetische Bauteile oder Materialien, wie z.B. Katalysatoren.

Insbesondere können sie z.B. als Sensoren für geringe Konzentrationen von biologischen oder chemischen Spezies verwendet werden. Durch den Einsatz der erfindungsgemäßen Strukturen können gegebenenfalls Reaktionen von biologischen Zellen oder in Mikroreaktoren ausgelöst und gesteuert werden. Durch eine geeignete Morphologie können selbstreinigende Oberflächen gebildet werden, z.B. durch Ausbildung einer den sogenannten "Lotuseffekt" bewirkenden Oberflächenmorphologie

Im Weiteren wird die Erfindung an einem Ausführungsbeispiel näher erläutert, dass den Umfang der Erfindung aber in keiner Weise beschränken soll.

### Beispiel

Ein Siliziumwaferstück von 1 x 1 cm² wurde in einer Apparatur beschichtet, die aus einem Glasrohr mit zylindrischem Querschnitt (Durchmesser 4 cm, Länge ca. 50 cm) besteht. Auf einer Seite des Rohres ist ein Vakuumpumpensystem (Drehschieberpumpe und Druckmessgerät) angeschlossen. Auf der entgegengesetzten Seite des Glasrohres ist ein Vorratsgefäß angeschlossen, das mit dem Precursor Aluminium-tert.-butoxydihydrid gefüllt ist. Die Beheizung erfolgte induktiv über eine Kupfer-umwicklung des Reaktionsrohres. Als Unterlage für das Siliziumwaferstück, auf das der Precursor abgeschieden werden soll, dient ein Graphitblock. Die Temperaturkontrolle erfolgte bei dieser Anordnung über ein Thermoelement. In dem Experiment wird der Graphitblock auf 600°C erhitzt. Aluminium-tert.-butoxydihydrid wurde 30 min lang aus dem Vorratsgefäß bei 0°C in den Reaktionsraum überführt und dort unter Bildung von mehreren 100 nm langen Aluminium-Aluminiumoxid-Nanokabeln zersetzt, die einen Durchmesser von etwa 30 nm besitzen.

Zur Charakterisierung der auf einem Siliziumwafer abgeschiedene Nanokabel wurden Raster-Elektronen-Mikroskopie und Raster-Kraft-Mikroskopie (REM) durchgeführt. Fig. 1 zeigt eine REM-Aufnahme der erfindungsgemäßen Struktur, die die eindimensionale Struktur des gebildeten Materials zeigt.

Durch Elektronen-Dispersive-Röntgenanalyse wurde ein Elementverhältnis Al:O von 1:1 festgestellt. Mittels Röntgenbeugung wurde das Vorhandensein von metallischem (elementarem) Aluminium nachgewiesen. Durch Transmissions-Elektronen-Mikroskopie (TEM) wurde der Aufbau der gebildeten Nanodrähte aus metallischem Kern und keramischer Hülle nachgewiesen. Fig. 2 zeigt eine TEM-Aufnahme mit der erfindungsgemäßen Struktur aus Metallkern und Keramikhülle.

## Patentansprüche

1. Eindimensionale Kompositstruktur, die mindestens einen Nanodraht umfassend einen metallischen Kern, der mit einem Metalloxid ummantelt ist, oder mindestens eine verzweigte Struktur, die aus solchen Nanodrähten aufgebaut ist, umfasst, wobei das Metall des Kerns ein Metall der III. Hauptgruppe ist.

2. Eindimensionale Kompositstruktur nach Anspruch 1, **dadurch gekennzeichnet, dass** die Metalloxid-Hülle eine Keramik ist.

3. Eindimensionale Kompositstruktur nach einem der Ansprüche 1 oder 2, **dadurch gekennzeichnet, dass** das Metall des Metalloxids ein Metall der III. Hauptgruppe ist.

4. Eindimensionale Kompositstruktur nach einem der Ansprüche 1 bis 3, **dadurch gekennzeichnet, dass** das Metall des Metalloxids und das Metall des Kerns das gleiche Metall der III. Hauptgruppe sind.

5. Eindimensionale Kompositstruktur nach einem der Ansprüche 1 bis 4, **dadurch gekennzeichnet, dass** das Metall Aluminium oder Gallium ist und das Metalloxid Aluminiumoxid oder Galliumoxid ist.

6. Eindimensionale Kompositstruktur nach einem der Ansprüche 1 bis 5, **dadurch gekennzeichnet, dass** der Nanodraht zwei Dimensionen im Bereich von 10 bis 100 nm aufweist.

7. Eindimensionale Kompositstruktur nach einem der Ansprüche 1 bis 6, **dadurch gekennzeichnet, dass** sie sich auf einem Substrat befindet.

8. Verwendung der eindimensionalen Kompositstruktur nach einem der Ansprüche 1 bis 7 für elektronische, optische oder magnetische Bauteile oder Materialien, als Sensor zum Nachweis von geringen Konzentrationen biologischer oder chemischer Spezies, zur Beeinflussung und Steuerung von Zellen in biologischen Systemen oder zur Erzeugung von selbstreinigenden Oberflächen.

9. Verfahren zur Herstellung einer eindimensionalen Kompositstruktur nach einem der Ansprüche 1 bis 7, bei dem mindestens eine metallorganische Verbindung der allgemeinen Formel
El(OR)H₂
worin El Al, Ga, In oder Tl bedeutet und R für einen aliphatischen oder alicyclischen Kohlenwasserstoffrest steht, bei einer Temperatur von mehr als 400°C unter Bildung der Kompositstruktur thermolytisch zersetzt wird.

10. Verfahren nach Anspruch 9, **dadurch gekennzeichnet, dass** El Al oder Ga ist.

11. Verfahren nach Anspruch 9 oder 10, **dadurch gekennzeichnet, dass** Aluminium-tert.-butoxydihydrid oder Gallium-tert.-butoxydihydrid als metallorganische Verbindung verwendet werden.

12. Verfahren nach einem der Ansprüche 9 bis 11, **dadurch gekennzeichnet, dass** die thermolytische Zersetzung auf oder an einem Substrat stattfindet.

13. Verfahren nach Anspruch 12, **dadurch gekennzeichnet, dass** das Substrat ein halbleitendes oder nichtleitendes Material ist.

14. Verfahren nach einem der Ansprüche 9 bis 13, **dadurch gekennzeichnet, dass** die thermolytische Zersetzung an einem elektrisch leitenden, induktiv geheizten Substrat, an einer in einem Ofen befindlichen Oberfläche oder an einer auf einem induktiv geheizten, elektrisch leitenden Substrathalter befindlichen Oberfläche stattfindet.

15. Verfahren nach Anspruch 14, **dadurch gekennzeichnet, dass** das elektrisch leitende, induktiv geheizte substrat ein Metall ist.

16. Verfahren nach einem der Ansprüche 9 bis 15, **dadurch gekennzeichnet, dass** die thermolytische Zersetzung unter Abwesenheit von Katalysatoren und Templaten durchgeführt wird.

17. Verfahren nach einem der Ansprüche 9 bis 16, **dadurch gekennzeichnet, dass** die metallorganische Verbindung in einem Gasstrom unter einem Druck von 10⁻⁶ bis 1 mbar und bei einer Temperatur von 450°C bis 1200°C zersetzt wird.

18. Verfahren nach einem der Ansprüche 9 bis 17, **dadurch gekennzeichnet, dass** die morphologische Ausprägung der erfindungsgemäßen Struktur durch Variation eines oder mehrerer Prozessparameter ausgewählt aus Substrattemperatur, Gasdruck, Precursorvorlagentemperatur und Precursorfluss gesteuert wird.

19. Verfahren nach einem der Ansprüche 9 bis 18, **dadurch gekennzeichnet, dass** die eindimensionale Kompositstruktur von dem Substrat abgelöst wird.

## Claims

1. A one-dimensional composite structure which comprises at least one nanowire comprising a metallic core sheathed with a metal oxide, or at least one branched structure constructed from such nanowires, wherein the metal of the core is a metal from main group III.

2. The one-dimensional composite structure as claimed in claim 1, **characterized in that** the metal oxide sheath is a ceramic.

3. The one-dimensional composite structure as claimed in any of claims 1 or 2, **characterized in that** the metal of the metal oxide is a metal from main group III.

4. The one-dimensional composite structure as claimed in any of claims 1 to 3, **characterized in that** the metal of the metal oxide and the metal of the core are the same metal from main group III.

5. The one-dimensional composite structure as claimed in any of claims 1 to 4, **characterized in that** the metal is aluminum or gallium and the metal oxide is aluminum oxide or gallium oxide.

6. The one-dimensional composite structure as claimed in any of claims 1 to 5, **characterized in that** the nanowire has two dimensions in the range of 10 to 100 nm.

7. The one-dimensional composite structure as claimed in any of claims 1 to 6, **characterized in that** it is situated on a substrate.

8. The use of the one-dimensional composite structure as claimed in any of claims 1 to 7 for electronic, optical or magnetic components or materials, as a sensor for detecting low concentrations of biological or chemical species, for influencing and controlling cells in biological systems or for producing self-cleaning surfaces.

9. A method for producing a one-dimensional composite structure as claimed in any of claims 1 to 7, in which at least one metallo-organic compound of the general formula
El(OR)H₂
wherein El denotes Al, Ga, In or Tl and R represents an aliphatic or alicyclic hydrocarbon radical,
is thermolytically decomposed at a temperature of more than 400°C with the formation of the composite structure.

10. The method as claimed in claim 9, **characterized in that** El is Al or Ga.

11. The method as claimed in claim 9 or 10, **characterized in that** aluminum tert-butoxydihydride or gallium tert-butoxydihydride is used as the metallo-organic compound.

12. The method as claimed in any of claims 9 to 11, **characterized in that** the thermolytic decomposition takes place on or at a substrate.

13. The method as claimed in claim 12, **characterized in that** the substrate is a semiconducting or nonconductive material.

14. The method as claimed in any of claims 9 to 13, **characterized in that** the thermolytic decomposition takes place at an electrically conductive, inductively heated substrate, at a surface situated in a furnace or at a surface situated on an inductively heated, electrically conductive substrate holder.

15. The method as claimed in claim 14, **characterized in that** the electrically conductive, inductively heated substrate is a metal.

16. The method as claimed in any of claims 9 to 15, **characterized in that** the thermolytic decomposition is carried out in the absence of catalysts and templates.

17. The method as claimed in any of claims 9 to 16, **characterized in that** the metallo-organic compound is decomposed in a gas stream under a pressure of 10⁻⁶ to 1 mbar and at a temperature of 450°C to 1200°C.

18. The method as claimed in any of claims 9 to 17, **characterized in that** the morphological fashioning of the structure according to the invention is controlled by varying one or more process parameters selected from substrate temperature, gas pressure, precursor feed temperature, and precursor flow.

19. The method as claimed in any of claims 9 to 18, **characterized in that** the one-dimensional composite structure is detached from the substrate.

## Revendications

1. Structure composite unidimensionnelle qui comprend au moins un nanofil comportant une âme métallique entourée d'une enveloppe en oxyde métallique ou au moins une structure ramifiée constituée de tels nanofils, le métal de l'âme étant un métal du groupe principal III.

2. Structure composite unidimensionnelle selon la revendication 1, **caractérisée en ce que** l'enveloppe en oxyde métallique est une céramique.

3. Structure composite unidimensionnelle selon l'une des revendications 1 ou 2, **caractérisée en ce que** le métal de l'oxyde métallique est un métal du groupe principal III.

4. Structure composite unidimensionnelle selon l'une des revendications 1 à 3, **caractérisée en ce que** le métal de l'oxyde métallique et le métal de l'âme sont le même métal du groupe principal III.

5. Structure composite unidimensionnelle selon l'une des revendications 1 à 4, **caractérisée en ce que** le métal est l'aluminium ou le gallium et l'oxyde métallique est l'oxyde d'aluminium ou l'oxyde de gallium.

6. Structure composite unidimensionnelle selon l'une des revendications 1 à 5, **caractérisée en ce que** le nanofil présente deux dimensions de l'ordre de 10 à 100 nm.

7. Structure composite unidimensionnelle selon l'une des revendications 1 à 6, **caractérisée en ce qu'**elle est située sur un substrat.

8. Utilisation d'une structure composite unidimensionnelle selon l'une des revendications 1 à 7 pour des composants ou matériaux électroniques, optiques ou magnétiques, comme capteur de détection de faibles concentrations de substances biologiques ou chimiques, pour agir et commander des cellules de systèmes biologiques ou pour former des surfaces autonettoyantes.

9. Procédé de fabrication d'une structure composite unidimensionnelle selon l'une des revendications 1 à 7, dans lequel au moins un composé organométallique de formule générale
El(OR)H₂
dans laquelle El représente Al, Ga, In ou Tl et R représente un groupe hydrocarbure aliphatique ou alicyclique, est décomposé thermolythiquement à une température supérieure à 400°C pour former la structure composite.

10. Procédé selon la revendication 9, **caractérisé en ce que** El représente Al ou Ga.

11. Procédé selon les revendications 9 ou 10, **caractérisé en ce qu'**il utilise comme composé organométallique le tert.-butoxydihydrure d'aluminium ou le tert.-butoxydihydrure de gallium.

12. Procédé selon l'une des revendications 9 à 11, **caractérisé en ce que** la décomposition thermolytique a lieu sur ou contre un substrat.

13. Procédé selon la revendication 12, **caractérisé en ce que** le substrat est un matériau semi-conducteur ou non conducteur.

14. Procédé selon l'une des revendications 9 à 13, **caractérisé en ce que** la décomposition thermolytique a lieu sur un substrat électriquement conducteur chauffé par induction, sur une surface placée dans un four ou sur une surface placée sur un porte-substrat électriquement conducteur chauffé par induction.

15. Procédé selon la revendication 14, **caractérisé en ce que** le substrat électriquement conducteur chauffé par induction est un métal.

16. Procédé selon l'une des revendications 9 à 15, **caractérisé en ce que** la décomposition thermolytique est réalisée en l'absence de catalyseurs et de gabarits.

17. Procédé selon l'une des revendications 9 à 16, **caractérisé en ce que** le composé organométallique est décomposé dans un écoulement de gaz sous une pression de 10⁻⁶ à 1 mbar et à une température de 450°C à 1200°C.

18. Procédé selon l'une des revendications 9 à 17, **caractérisé en ce que** l'empreinte morphologique de la structure selon l'invention est contrôlée par modification d'un ou plusieurs paramètres du traitement, sélectionné parmi la température du substrat, la pression du gaz, la température de la réserve de précurseur et le débit du précurseur.

19. Procédé selon l'une des revendications 9 à 18, **caractérisé en ce que** la structure composite unidimensionnelle est détachée du substrat.
